(19) Europäisches Patentamt
European Patent Office
Office européen des brevets

(11) **EP 4 631 913 A1**

(12) **EUROPEAN PATENT APPLICATION**
published in accordance with Art. 153(4) EPC

(43) Date of publication:
**15.10.2025 Bulletin 2025/42**

(21) Application number: **23900695.0**

(22) Date of filing: **06.12.2023**

(51) International Patent Classification (IPC):
*C01B 33/18* (2006.01)    *C01B 33/141* (2006.01)
*C09K 3/14* (2006.01)    *H01L 21/304* (2006.01)

(52) Cooperative Patent Classification (CPC):
**C01B 33/141; C01B 33/18; C09K 3/14;
H01L 21/304**

(86) International application number:
**PCT/JP2023/043677**

(87) International publication number:
**WO 2024/122583 (13.06.2024 Gazette 2024/24)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **08.12.2022 JP 2022196462**

(71) Applicant: **Mitsubishi Chemical Corporation
Tokyo 100-8251 (JP)**

(72) Inventors:
• **KATO, Tomohiro
Tokyo 100-8251 (JP)**
• **SAWAI, Takeshi
Tokyo 100-8251 (JP)**

(74) Representative: **Hoffmann Eitle
Patent- und Rechtsanwälte PartmbB
Arabellastraße 30
81925 München (DE)**

(54) **SILICA PARTICLE, PRODUCTION METHOD FOR SILICA PARTICLE, SILICA SOL, POLISHING COMPOSITION, POLISHING METHOD, MANUFACTURING METHOD FOR SEMICONDUCTOR WAFER, AND MANUFACTURING METHOD FOR SEMICONDUCTOR DEVICE**

(57)    An object of the present invention is to provide a silica particle in which a metal content, particularly a content of a specific metal, has been significantly reduced. The gist of the present invention is as follows. A silica particle satisfying at least one of the following characteristics (a) to (c).
(a) A content of sodium is 15 ppb by mass or less.
(b) A content of potassium is 5 ppb by mass or less.
(c) A content of calcium is 9 ppb by mass or less.

EP 4 631 913 A1

**Description**

Technical Field

The present invention relates to a silica particle, a method for producing silica particle, a silica sol, a polishing composition, a polishing method, a method for manufacturing a semiconductor wafer, and a method for manufacturing a semiconductor device.

Background Art

A polishing method using a polishing liquid is known as a method for polishing a surface of a material such as a metal and an inorganic compound. In particular, in the final finishing polishing of prime silicon wafers for semiconductors and their regenerated silicon wafers, and in chemical mechanical polishing (CMP) such as planarization of interlayer insulating films, formation of metal plugs, formation of embedded wiring, and the like, when manufacturing semiconductor devices, the surface condition greatly affects the semiconductor characteristics. For this reason, the surfaces and end faces of these parts are required to be polished with extremely high precision.

In such precision polishing, a polishing composition containing silica particles is used. Colloidal silica is widely used as the abrasive grains, which are the main component of this polishing composition. Colloidal silica is known to be produced by a variety of methods, including those produced by a thermal decomposition of silicon tetrachloride (fumed silica and the like), those produced by a deionization of alkali silicate such as water glass and the like, and those produced by a hydrolysis reaction and a condensation reaction of an alkoxysilane (commonly known as the "sol-gel method").

Many studies have been conducted on methods for producing a silica particle. For example, Patent Literatures 1 to 3 disclose methods for producing a silica particle by a hydrolysis reaction and a condensation reaction of an alkoxysilane.

Citation List

Patent Literature

Patent Literature 1: WO 2008/015943 A

Patent Literature 2: JP 2018-80331 A

Patent Literature 3: JP 2010-83744 A

Summary of Invention

Technical Problem

When silica particles having a high metal content are used for polishing, the metal contained in the silica particles adheres to the surface of the polished object, and contaminates the polished object. The contamination of the polished object adversely affects the performance of the object to which it is applied. For this reason, particularly in semiconductor applications, silica particles are required to have a high level of reduction in metal content.

The silica particles disclosed in Patent Literatures 1 to 3 have a low metal content, but the level of reduction is not sufficient. In particular, it is desirable to further reduce the content of metals such as sodium and potassium, which are likely to be mixed in from the environment, and the content of metals that are likely to undergo chemical reactions with the polished object during or after semiconductor polishing, to a lower level than the conventional silica particles.

An object of the present invention is to provide a silica particle in which a metal content, particularly a content of a specific metal, has been significantly reduced.

Solution to Problem

The conventional silica particle, particularly a silica particle obtained by a hydrolysis reaction and a condensation reaction of an alkoxysilane, does not have a sufficiently reduced level of metal content.

As a result of extensive investigations, the inventors of the present invention discovered a silica particle having an extremely low metal content, and arrived at the present invention.

The gist of the present invention is as follows.

[1] A silica particle satisfying at least one of the following characteristics (a) to (c).

(a) A content of sodium is 15 ppb by mass or less.

(b) A content of potassium is 5 ppb by mass or less.

(c) A content of calcium is 9 ppb by mass or less.

[2] The silica particle according to [1], wherein the silica particle satisfies at least two of the characteristics (a) to (c).

[3] The silica particle according to [2], wherein the silica particle satisfies all of the characteristics (a) to (c).

[4] The silica particle according to any one of [1] to [3], wherein the silica particle has a metal content of 50 ppb by mass or less.

[5] The silica particle according to any one of [1] to [4], wherein the silica particle is amorphous.

[6] The silica particle according to any one of [1] to [5], wherein the silica particle is mainly composed of an alkoxysilane condensate.

[7] A method for producing the silica particle according to any one of [1] to [6], wherein the method comprises a step in which tetraalkoxysilane is subjected to a hydrolysis reaction and a condensation reaction in a reaction vessel having an inner wall surface coated with a fluororesin.

[8] The method for producing the silica particle according to [7], wherein the reaction vessel is a reaction vessel having a contact area of the reaction solution per unit volume with the reaction vessel during the hydrolysis reaction and the condensation reaction of 5 $m^{-1}$ or less.

[9] The method for producing the silica particle according to [7] or [8], wherein a metal content of the tetraalkoxysilane is 50 ppb by mass or less.

[10] A silica sol comprising the silica particle according to any one of [1] to [6].

[11] The silica sol according to [10], wherein a content of the silica particle is 2% by mass to 50% by mass in a total amount of 100% by mass of the silica sol.

[12] A polishing composition comprising the silica sol according to [10] or [11].

[13] A polishing method using the polishing composition according to [12].

[14] The polishing method according to [13], wherein the polishing method using the polishing composition is conducted in a final polishing step in a polishing process.

[15] A method for manufacturing a semiconductor wafer, wherein the method comprises a step of polishing using the polishing composition according to [12].

[16] A method for manufacturing a semiconductor device, wherein the method comprises a step of polishing using the polishing composition according to [12].

Advantageous Effects of Invention

The silica particle of the present invention has an extremely low metal content, and when used for polishing, it can suppress the adhesion of metal to a surface of an object to be polished. This reduces contamination of the object to be polished and the adverse effects on the performance of a device to which the object to be polished is applied.

Description of Embodiments

The present invention is described in detail below. The present invention is not limited to the following embodiments, and can be carried out with various modifications within the scope of the gist.

When the expression **"to"** is used in this specification, it is used as an expression including the numerical value or physical property value before and after it.

(Silica particle)

The silica particle of the present invention is a silica particle that satisfies at least one of the following characteristics (a) to (c).

(a) A content of sodium is 15 ppb by mass or less.

(b) A content of potassium is 5 ppb by mass or less.

(c) A content of calcium is 9 ppb by mass or less.

The silica particle of the present invention preferably satisfies at least two of the characteristics (a) to (c), and more preferably satisfies all of the characteristics (a) to (c).

The silica particle of the present invention that satisfies the above mentioned characteristic (a) has a sodium content of 15 ppb by mass or less.

When the sodium content of the silica particle is 15 ppb by mass or less, it is preferable because it reduces contamination caused by the sodium adhering to the surface of the object to be polished when used for polishing, and the effect of this on the performance of a device to which the object to be polished is applied. In particular, in semiconductor applications, it is preferable because it reduces deterioration of quality caused by the sodium adhering to the surface of the object to be polished diffusing into the object to be polished, and a decrease in the performance of semiconductor devices manufactured using such objects to be polished.

The sodium content of the silica particle is preferably 12 ppb by mass or less, and more preferably 10 ppb by mass or less, because the above mentioned performance is significantly superior. The sodium content of the silica particle is 0 ppb by mass or more, and is preferably 0.0001 ppb by mass or more because it is easy to produce.

The silica particle of the present invention that satisfies the above mentioned characteristic (b) has a potassium content of 5 ppb by mass or less.

When the potassium content of the silica particle is 5 ppb by mass or less, it is preferable because it reduces contamination caused by the potassium adhering to the surface of the object to be polished when used for polishing, and the effect of this on the performance of a device to which the object to be polished is applied. In particular, in semiconductor applications, it is preferable because it reduces deterioration of quality caused by the potassium adhering to the surface of the object to be polished diffusing into the object to be polished, and a decrease in the performance of semiconductor devices manufactured using such objects to be polished.

The potassium content of the silica particle is preferably 2 ppb by mass or less, and more preferably 0.5 ppb by mass or less, because the above mentioned performance is significantly superior. The potassium content of the silica particle is 0 ppb by mass or more, and is preferably 0.0001 ppb by mass or more because it is easy to produce.

The silica particle of the present invention that satisfies the above mentioned characteristic (c) has a calcium content of 9 ppb by mass or less.

When the calcium content of the silica particle is 9 ppb by mass or less, it is preferable because it reduces contamination caused by the calcium adhering to the surface of the object to be polished when used for polishing, and the effect of this on the performance of a device to which the object to be polished is applied. In particular, in semiconductor applications, it is preferable because it reduces deterioration of quality such as pit formation caused by catalytic chemical reactions between calcium and the object to be polished caused by the calcium adhering to the surface of the object to be polished diffusing into the object to be polished, and a decrease in the performance of semiconductor devices manufactured using such objects to be polished.

The calcium content of the silica particle is preferably 7 ppb by mass or less, and more preferably 6 ppb by mass or less, because the above mentioned performance is significantly superior. The calcium content of the silica particle is 0 ppb by mass or more, and is preferably 0.0001 ppb by mass or more because it is easy to produce.

The silica particle of the present invention preferably has a cobalt content of 1 ppb by mass or less, more preferably 0.7 ppb by mass or less, and even more preferably 0.5 ppb by mass or less. When the cobalt content of the silica particle is within the above range, it is preferable because it reduces contamination caused by the cobalt adhering to the surface of the object to be polished when used for polishing, and the effect of this on the performance of a device to which the object to be polished is applied. In particular, in semiconductor applications, it is preferable because it reduces deterioration of quality caused by the cobalt adhering to the surface of the object to be polished diffusing into the object to be polished, and a decrease in the performance of semiconductor devices manufactured using such objects to be polished. The cobalt content of the silica particle is 0 ppb by mass or more, and is preferably 0.0001 ppb by mass or more because it is easy to produce.

The silica particle of the present invention preferably has a magnesium content of 1.5 ppb by mass or less, and more preferably 0.5 ppb by mass or less. When the magnesium content of the silica particle is within the above range, it is preferable because it reduces contamination caused by the magnesium adhering to the surface of the object to be polished when used for polishing, and the effect of this on the performance of a device to which the object to be polished is applied. In particular, in semiconductor applications, it is preferable because it reduces deterioration of quality caused by the magnesium adhering to the surface of the object to be polished diffusing into the object to be polished, and a decrease in the performance of semiconductor devices manufactured using such objects to be polished. The magnesium content of the silica particle is 0 ppb by mass or more, and is preferably 0.0001 ppb by mass or more because it is easy to produce.

The silica particle of the present invention preferably has an aluminum content of 2 ppb by mass or less, and more preferably 1.2 ppb by mass or less. When the aluminum content of the silica particle is within the above range, it is preferable because it reduces contamination caused by the aluminum adhering to the surface of the object to be polished when used for polishing, and the effect of this on the performance of a device to which the object to be polished is applied. In particular, in semiconductor applications, it is preferable because it reduces deterioration of quality caused by the aluminum adhering to the surface of the object to be polished diffusing into the object to be polished, and a decrease in the performance of semiconductor devices manufactured using such objects to be polished. The aluminum content of the silica particle is 0 ppb by mass or more, and is preferably 0.0001 ppb by mass or more because it is easy to produce.

The silica particle of the present invention preferably has a chromium content of 1 ppb by mass or less, and more preferably 0.5 ppb by mass or less. When the chromium content of the silica particle is within the above range, it is preferable because it reduces contamination caused by the chromium adhering to the surface of the object to be polished when used for polishing, and the effect of this on the performance of a device to which the object to be polished is applied. In particular, in semiconductor applications, it is preferable because it reduces deterioration of quality caused by the chromium adhering to the surface of the object to be polished diffusing into the object to be polished, and a decrease in the performance of semiconductor devices manufactured using such objects to be polished. The chromium content of the silica particle is 0 ppb by mass or more, and is preferably 0.0001 ppb by mass or more because it is easy to produce.

The silica particle of the present invention preferably has a manganese content of 1 ppb by mass or less, and more preferably 0.5 ppb by mass or less. When the manganese content of the silica particle is within the above range, it is preferable because it reduces contamination caused by the manganese adhering to the surface of the object to be polished when used for polishing, and the effect of this on the performance of a device to which the object to be polished is applied. In particular, in semiconductor applications, it is preferable because it reduces deterioration of quality caused by the manganese adhering to the surface of the object to be polished diffusing into the object to be polished, and a decrease in the performance of semiconductor devices manufactured using such objects to be polished. The manganese content of the silica particle is 0 ppb by mass or more, and is preferably 0.0001 ppb by mass or more because it is easy to produce.

The silica particle of the present invention preferably has an iron content of 1 ppb by mass or less, and more preferably 0.6 ppb by mass or less. When the iron content of the silica particle is within the above range, it is preferable because it reduces contamination caused by the iron adhering to the surface of the object to be polished when used for polishing, and the effect of this on the performance of a device to which the object to be polished is applied. In particular, in semiconductor applications, it is preferable because it reduces deterioration of quality such as pit formation caused by catalytic chemical reactions between iron and the object to be polished caused by the iron adhering to the surface of the object to be polished diffusing into the object to be polished, and a decrease in the performance of semiconductor devices manufactured using such objects to be polished. The iron content of the silica particle is 0 ppb by mass or more, and is preferably 0.0001 ppb by mass or more because it is easy to produce.

The silica particle of the present invention preferably has a nickel content of 1 ppb by mass or less, and more preferably 0.5 ppb by mass or less. When the nickel content of the silica particle is within the above range, it is preferable because it reduces contamination caused by the nickel adhering to the surface of the object to be polished when used for polishing, and the effect of this on the performance of a device to which the object to be polished is applied. In particular, in semiconductor applications, it is preferable because it reduces deterioration of quality caused by the nickel adhering to the surface of the object to be polished diffusing into the object to be polished, and a decrease in the performance of semiconductor devices manufactured using such objects to be polished. The nickel content of the silica particle is 0 ppb by mass or more, and is preferably 0.0001 ppb by mass or more because it is easy to produce.

The silica particle of the present invention preferably has a zinc content of 15 ppb by mass or less, and more preferably 12 ppb by mass or less. When the zinc content of the silica particle is within the above range, it is preferable because it reduces contamination caused by the zinc adhering to the surface of the object to be polished when used for polishing, and the effect of this on the performance of a device to which the object to be polished is applied. In particular, in semiconductor applications, it is preferable because it reduces deterioration of quality caused by the zinc adhering to the surface of the object to be polished diffusing into the object to be polished, and a decrease in the performance of semiconductor devices manufactured using such objects to be polished. The zinc content of the silica particle is 0 ppb by mass or more, and is preferably 0.0001 ppb by mass or more because it is easy to produce.

The silica particle of the present invention preferably has a copper content of 1 ppb by mass or less, and more preferably 0.5 ppb by mass or less. When the copper content of the silica particle is within the above range, it is preferable because it reduces contamination caused by the copper adhering to the surface of the object to be polished when used for polishing, and the effect of this on the performance of a device to which the object to be polished is applied. In particular, in semiconductor applications, it is preferable because it reduces deterioration of quality caused by the copper adhering to the surface of the object to be polished diffusing into the object to be polished, and a decrease in the performance of semiconductor devices manufactured using such objects to be polished. The copper content of the silica particle is 0 ppb by mass or more, and is preferably 0.0001 ppb by mass or more because it is easy to produce.

The silica particle of the present invention preferably has a lead content of 1 ppb by mass or less, and more preferably 0.5 ppb by mass or less. When the lead content of the silica particle is within the above range, it is preferable because it reduces contamination caused by the lead adhering to the surface of the object to be polished when used for polishing, and the effect of this on the performance of a device to which the object to be polished is applied. In particular, in semiconductor applications, it is preferable because it reduces deterioration of quality caused by the lead adhering to the surface of the object to be polished diffusing into the object to be polished, and a decrease in the performance of semiconductor devices manufactured using such objects to be polished. The lead content of the silica particle is 0 ppb by mass or more, and is preferably 0.0001 ppb by mass or more because it is easy to produce.

The silica particle of the present invention preferably has a titanium content of 2 ppb by mass or less, and more preferably 1.2 ppb by mass or less. When the titanium content of the silica particle is within the above range, it is preferable because it reduces contamination caused by the titanium adhering to the surface of the object to be polished when used for polishing, and the effect of this on the performance of a device to which the object to be polished is applied. In particular, in semiconductor applications, it is preferable because it reduces deterioration of quality caused by the titanium adhering to the surface of the object to be polished diffusing into the object to be polished, and a decrease in the performance of semiconductor devices manufactured using such objects to be polished. The titanium content of the silica particle is 0 ppb by mass or more, and is preferably 0.0001 ppb by mass or more because it is easy to produce.

The silica particle of the present invention preferably has a silver content of 1 ppb by mass or less, and more preferably 0.5 ppb by mass or less. When the silver content of the silica particle is within the above range, it is preferable because it reduces contamination caused by the silver adhering to the surface of the object to be polished when used for polishing, and the effect of this on the performance of a device to which the object to be polished is applied. In particular, in semiconductor applications, it is preferable because it reduces deterioration of quality caused by the silver adhering to the surface of the object to be polished diffusing into the object to be polished, and a decrease in the performance of semiconductor devices manufactured using such objects to be polished. The silver content of the silica particle is 0 ppb by mass or more, and is preferably 0.0001 ppb by mass or more because it is easy to produce.

The silica particle of the present invention preferably has a metal content of 50 ppb by mass or less, more preferably 40 ppb by mass or less, and even more preferably 35 ppb by mass or less. When the metal content of the silica particle is within the above range, it is preferable because it reduces contamination caused by the metal adhering to the surface of the object to be polished when used for polishing, and the effect of this on the performance of a device to which the object to be polished is applied. In particular, in semiconductor applications, it is preferable because it reduces deterioration of quality caused by the metal adhering to the surface of the object to be polished diffusing into the object to be polished, and a decrease in the performance of semiconductor devices manufactured using such objects to be polished. The metal content of the silica particle is 0 ppb by mass or more, and is preferably 0.0001 ppb by mass or more because it is easy to produce.

Furthermore, when the metal content of the silica particle is 50 ppb by mass or less, it is preferable because it reduces the effect on the polishing rate caused by changes in the chemical properties (acidity and the like) of the surface silanol groups and changes in the three-dimensional environment of the silica particle surface (ease of the aggregation of the silica particles, and the like), due to the occurrence of coordination interactions between the acidic surface silanol groups and the contained metals.

The content of each metal of the silica particle in the present specification is a value measured by High-frequency Inductively Coupled Plasma Mass Spectrometry (ICP-MS). Specifically, 0.4 g of silica particles or silica sol containing 0.4 g of silica particles is accurately weighed, sulfuric acid and hydrofluoric acid are added, and the mixture is heated, dissolved, and evaporated, and pure water is added to the remaining sulfuric acid droplets so that the total amount is exactly 10 g to prepare a test liquid. The obtained test liquid is measured using a high-frequency inductively coupled plasma mass spectrometer. The target metals are sodium, potassium, cobalt, magnesium, aluminum, calcium, chromium, manganese, iron, nickel, zinc, copper, lead, titanium, and silver, and the sum of the contents of these metals is the metal content.

In the produce of silica particles by the sol-gel method, in order to make the content of each of the above mentioned metals in the obtained silica particles equal to or less than the above mentioned upper limit and to make the total content equal to or less than 50 ppb by mass, for example, the following measures may be appropriately selected and adopted.

(1) A tetraalkoxysilane having a metal content of 50 ppb by mass or less is used as the raw material.

(2) A hydrolysis reaction and a condensation reaction of a tetraalkoxysilane are carried out in a reaction vessel having an inner wall surface coated with a fluororesin or a glass layer.

(3) A reaction vessel used is one in which a contact area of the reaction solution per unit volume with a reaction vessel during a hydrolysis reaction and a condensation reaction is 5 $m^{-1}$ or less.

These may also be used in combination of two or more.

In a method for producing of silica particles by deionization of alkali silicate such as water glass, sodium and other impurities derived from raw materials remain, making it extremely difficult to make the content of the metal impurity of the obtained silica particles equal or less than 50 ppb by mass.

The average primary particle diameter of the silica particle of the present invention is preferably 5 nm to 100 nm, and more preferably 15 nm to 60 nm. When the average primary particle diameter of the silica particles is 5 nm or more, the storage stability of the silica sol is excellent. When the average primary particle diameter of the silica particles is 100 nm or less, the surface roughness and scratches of the object to be polished, such as a silicon wafer, can be reduced, and the sedimentation of the silica particles can be suppressed.

The average primary particle diameter of the silica particles is measured by the BET method. Specifically, the specific surface area of the silica particles is measured using an automatic specific surface area measuring device, and the average primary particle diameter is calculated using the following formula (1).

$$\text{Average primary particle diameter (nm)} = 6000 / (\text{specific surface area } (m^2/g) \times \text{density } (g/cm^3)) \qquad (1)$$

The average primary particle diameter of the silica particles can be set to a desired range depending on the producing conditions of the silica particles.

The average secondary particle diameter of the silica particle of the present invention is preferably 10 nm to 200 nm, and more preferably 30 nm to 100 nm. When the average secondary particle diameter of the silica particles is 10 nm or more, the removability of particles and the like during cleaning after polishing is excellent, and the storage stability of the silica sol is excellent. When the average secondary particle diameter of the silica particles is 200 nm or less, the surface roughness and scratches of the object to be polished, such as a silicon wafer, during polishing can be reduced, the removability of particles and the like during cleaning after polishing is excellent, and the sedimentation of the silica particles can be suppressed.

The average secondary particle diameter of the silica particles is measured by the DLS method. Specifically, it is measured using a dynamic light scattering particle diameter measuring device.

The average secondary particle diameter of the silica particles can be set to a desired range depending on the producing conditions of the silica particles.

The cv value of the silica particle of the present invention is preferably 10% to 50%, more preferably 15% to 40%, and even more preferably 20% to 35%. When the cv value of the silica particles is 10% or more, the polishing rate for the object to be polished, such as a silicon wafer, is excellent, and the productivity of the silicon wafer is excellent. When the cv value of the silica particles is 50% or less, the surface roughness and scratches of the object to be polished, such as a silicon wafer, during polishing can be reduced, and the removability of particles and the like during cleaning after polishing is excellent.

The cv value of the silica particles is calculated using the following formula (2) by measuring the average secondary particle diameter of the silica particles using a dynamic light scattering particle diameter measuring device.

$$\text{cv value} = (\text{standard deviation (nm)} / \text{average secondary particle diameter (nm)}) \times 100 \qquad (2)$$

The association ratio of the silica particle of the present invention is preferably 1.0 to 4.0, and more preferably 1.1 to 3.0. When the association ratio of the silica particles is 1.0 or more, the polishing rate for the object to be polished, such as a silicon wafer, is excellent, and the productivity of silicon wafers is excellent. When the association ratio of the silica particles is 4.0 or less, the surface roughness and scratches of the object to be polished, such as a silicon wafer, during polishing can be reduced, and the aggregation of the silica particles can be suppressed.

The association ratio of the silica particles is calculated using the following formula (3) from the average primary particle diameter measured by the above mentioned measurement method and the average secondary particle diameter measured by the above mentioned measurement method.

Association ratio = average secondary particle diameter / average primary particle diameter       (3)

The surface silanol group density of the silica particle of the present invention is preferably $1/nm^2$ to $8/nm^2$, and more preferably $4/nm^2$ to $7/nm^2$. When the surface silanol group density of the silica particles is $1/nm^2$ or more, the silica particles have appropriate surface repulsion, and the dispersion stability of the silica sol is excellent. When the surface silanol group density of the silica particles is $8/nm^2$ or less, the silica particles have a suitable surface repulsion, and the aggregation of the silica particles can be suppressed.

The surface silanol group density of the silica particles is measured by the Sears method. Specifically, it is measured and calculated under the conditions shown below.

A silica sol equivalent to **1.5** g of silica particles is collected, and pure water is added to make the liquid volume 90 **mL.** To this, 0.1 mol/L hydrochloric acid aqueous solution is added until the pH becomes **3.6** in an environment of 25°C, 30 g of sodium chloride is added, and pure water is gradually added to completely dissolve the sodium chloride, and finally pure water is added until the total volume of the test liquid is 150 mL to obtain a test liquid.

The obtained test liquid is placed in an automatic titration device, and 0.1 mol/L sodium hydroxide aqueous solution is dropped to measure the titration amount A (mL) of 0.1 mol/L sodium hydroxide aqueous solution required to change the pH from 4.0 to 9.0.

The consumption amount V (mL) of 0.1 mol/L sodium hydroxide solution required to change the pH from 4.0 to 9.0 per 1.5 g of silica particles is calculated using the following formula (4). And the surface silanol group density $\rho$ (pieces/nm$^2$) of the silica particles is calculated using the following formula (5).

$$V = (A \times f \times 100 \times 1.5) / (W \times C) \ldots (4)$$

A: Titration amount (mL) of the 0.1 mol/L sodium hydroxide aqueous solution required to change the pH per 1.5 g of the silica particles from 4.0 to 9.0

f: Titer of the 0.1 mol/L sodium hydroxide aqueous solution used

C: Concentration of the silica particles in the silica sol (% by mass)

W: Amount of the silica sol collected (g)

$$\rho = (B \times N_A) / (10^{18} \times M \times S_{BET}) \ldots (5)$$

B: Amount (mol) of the sodium hydroxide required to change the pH of the silica particles per 1.5g from 4.0 to 9.0 calculated from V

$N_A$: Avogadro's number (pieces/mol)

M: Amount of the silica particles (1.5 g)

$S_{BET}$: Specific surface area (m$^2$/g) of the silica particles measured when calculating the average primary particle diameter

The silica particle of the present invention is preferably amorphous, since it can suppress scratching of the object to be polished while achieving an excellent polishing rate, and has a suitable hardness so that it does not easily adhere to the object to be polished. The fact that the silica particle is amorphous can be confirmed by a halo pattern in a wide-angle X-ray scattering measurement.

Since having a low content of metal impurities and excellent mechanical strength and storage stability, the silica particle of the present invention preferably contains an alkoxysilane condensate as a main component, more preferably contains a tetraalkoxysilane condensate as a main component, and even more preferably contains a tetramethoxysilane condensate as a main component. The main component refers to a component that accounts for 50% by mass or more in 100% by mass of all components constituting the silica particle.

In order to obtain the silica particle mainly composed of the alkoxysilane condensate, it is preferable to use an alkoxysilane as the main raw material. In order to obtain the silica particle mainly composed of the tetraalkoxysilane condensate, it is preferable to use a tetraalkoxysilane as the main raw material. In order to obtain the silica particle mainly composed of the tetramethoxysilane condensate, it is preferable to use tetramethoxysilane as the main raw material. The main raw material refers to a raw material that accounts for 50% by mass or more in 100% by mass of all raw materials constituting the silica particle.

(Method for producing silica particles)

The silica particle of the present invention can be obtained by a method including a step in which tetraalkoxysilane is subjected to a hydrolysis reaction and a condensation reaction.

The method for producing the silica particle of the present invention is preferably a method comprising adding a solution (B) containing a tetraalkoxysilane and a solution (C) containing an alkaline catalyst to a solution (A) containing water, and subjecting the tetraalkoxysilane to the hydrolysis and condensation reactions.

This method makes it easier to control the hydrolysis reaction and the condensation reaction, can increase the reaction rate of the hydrolysis reaction and the condensation reaction, prevent gelation of the silica particle dispersion, and produce silica particles having a uniform particle diameter.

The solution (A) contains water.

It is preferable that the solution (A) contains a solvent other than water, since it has excellent dispersibility in the reaction solution of the tetraalkoxysilane.

Examples of the solvent other than water in the solution (A) include methanol, ethanol, propanol, isopropanol, ethylene glycol, and the like. These solvents may be used alone or in combination of two or more. Among these solvents, alcohols are preferable, methanol and ethanol are more preferable, and methanol is even more preferable. These alcohols easily dissolve the tetraalkoxysilane, and are excellent in convenience in production because the by-products are the same as those used in the hydrolysis reaction and the condensation reaction.

The solution (A) preferably contains an alkaline catalyst, since this can increase the reaction rate of the hydrolysis reaction and the condensation reaction of the tetraalkoxysilane.

Examples of the alkaline catalyst in the solution (A) include ethylenediamine, diethylenetriamine, triethylenetetramine, ammonia, urea, ethanolamine, tetramethylammonium hydroxide, and the like. These alkaline catalysts may be used alone or in combination of two or more. Among these alkaline catalysts, ammonia is preferred. Ammonia has excellent catalytic action, is easy to control the particle shape, can suppress the inclusion of metal impurities, is highly volatile, and therefore easy to be removed after the hydrolysis reaction and the condensation reaction.

The concentration of water in the solution (A) is preferably 3% by mass to 50% by mass, and more preferably 5% by mass to 40% by mass, based on 100% by mass of the solution (A). When the concentration of water in the solution (A) is 3% by mass or more, the hydrolysis reaction rate of the tetraalkoxysilane is easy to control. When the concentration of water in the solution (A) is 50 % by mass or less, the reaction balance between the hydrolysis reaction and the condensation reaction is good, and the particle shape is easy to be controlled.

The concentration of the alkaline catalyst in the solution (A) is preferably 0.5% by mass to 2.0% by mass, and more preferably 0.6% by mass to 1.5% by mass, based on 100% by mass of the solution (A). When the concentration of the alkaline catalyst in the solution (A) is 0.5% by mass or more, the aggregation of the silica particles is suppressed, and the dispersion stability of the silica particles in the dispersion liquid is excellent. When the concentration of the alkaline catalyst in the solution (A) is 2.0% by mass or less, the reaction does not proceed excessively fast, and the reaction controllability is excellent.

The concentration of the solvent other than water in the solution (A) is preferably the balance of water and the alkaline catalyst.

The solution (B) contains a tetraalkoxysilane.

Examples of the tetraalkoxysilane in the solution (B) include tetramethoxysilane, tetraethoxysilane, tetrapropoxysilane, tetraisopropoxysilane, and the like. These tetraalkoxysilanes may be used alone or in combination of two or more. Among these tetraalkoxysilanes, tetramethoxysilane and tetraethoxysilane are preferred, and tetramethoxysilane is more preferred. These have a fast hydrolysis reaction rate, are less likely to leave unreacted materials, are excellent in productivity, and can easily produce a stable silica sol.

The raw material for the silica particle may be a raw material other than the tetraalkoxysilane, such as a low condensation product of the tetraalkoxysilane, and the like. However, it is preferable that the ratio of the tetraalkoxysilane is 50% by mass or more and the ratio of the raw materials other than the tetraalkoxysilane is 50% by mass or less, based on 100% by mass of the total raw materials constituting the silica particle. It is more preferable that the ratio of the tetraalkoxysilane is 90% by mass or more and the ratio of the raw materials other than the tetraalkoxysilane is 10% by mass or less, based on 100% by mass of the total raw materials constituting the silica particle. When the ratio of the tetraalkoxysilane in the raw materials is equal to or more than the above mentioned lower limit, the reactivity is excellent.

A sodium content of the tetraalkoxysilane is preferably 15 ppb by mass or less, more preferably 12 ppb by mass or less, and even more preferably 10 ppb by mass or less. When the sodium content of the tetraalkoxysilane is within the above range, it is preferable because the sodium content of the resulting silica particles is reduced, and when the silica particles are used for polishing, contamination caused by the sodium adhering to the surface of the object to be polished, and the effect of this on the performance of a device to which the object to be polished is applied. In particular, in semiconductor applications, it is preferable because it reduces deterioration of quality caused by the sodium adhering to the surface of the object to be polished diffusing into the object to be polished, and a decrease in the performance of semiconductor devices manufactured using such objects to be polished. The sodium content of the tetraalkoxysilane is 0 ppb by mass or more, and is preferably 0.0001 ppb by mass or more, because it is easy to produce.

A potassium content of the tetraalkoxysilane is preferably 5 ppb by mass or less, more preferably 2 ppb by mass or less, and even more preferably 0.5 ppb by mass or less. When the potassium content of the tetraalkoxysilane is within the above range, it is preferable because the potassium content of the resulting silica particles is reduced, and when the silica particles are used for polishing, contamination caused by the potassium adhering to the surface of the object to be polished, and the effect of this on the performance of a device to which the object to be polished is applied. In particular, in semiconductor applications, it is preferable because it reduces deterioration of quality caused by the potassium adhering to the surface of the object to be polished diffusing into the object to be polished, and a decrease in the performance of semiconductor devices manufactured using such objects to be polished. The potassium content of the tetraalkoxysilane is 0 ppb by mass or more, and is preferably 0.0001 ppb by mass or more because it is easy to produce.

A calcium content of the tetraalkoxysilane is preferably 9 ppb by mass or less, more preferably 7 ppb by mass or less, and even more preferably 6 ppb by mass or less. When the calcium content of the tetraalkoxysilane is within the above range, it is preferable because the calcium content of the resulting silica particles is reduced, and when the silica particles are used for polishing, contamination caused by the calcium adhering to the surface of the object to be polished, and the effect of this on the performance of a device to which the object to be polished is applied. In particular, in semiconductor applications, it is preferable because it reduces deterioration of quality caused by the calcium adhering to the surface of the object to be polished diffusing into the object to be polished, and a decrease in the performance of semiconductor devices manufactured using such objects to be polished. The calcium content of the tetraalkoxysilane is 0 ppb by mass or more, and is preferably 0.0001 ppb by mass or more because it is easy to produce.

A cobalt content of the tetraalkoxysilane is preferably 1 ppb by mass or less, more preferably 0.7 ppb by mass or less, and even more preferably 0.5 ppb by mass or less. When the cobalt content of the tetraalkoxysilane is within the above range, it is preferable because the cobalt content of the resulting silica particles is reduced, and when the silica particles are used for polishing, contamination caused by the cobalt adhering to the surface of the object to be polished, and the effect of this on the performance of a device to which the object to be polished is applied. In particular, in semiconductor applications, it is preferable because it reduces deterioration of quality caused by the cobalt adhering to the surface of the object to be polished diffusing into the object to be polished, and a decrease in the performance of semiconductor devices manufactured using such objects to be polished. The cobalt content of the tetraalkoxysilane is 0 ppb by mass or more, and is preferably 0.0001 ppb by mass or more because it is easy to produce.

A magnesium content of the tetraalkoxysilane is preferably 1.5 ppb by mass or less, and more preferably 0.5 ppb by mass or less. When the magnesium content of the tetraalkoxysilane is within the above range, it is preferable because the magnesium content of the resulting silica particles is reduced, and when the silica particles are used for polishing, contamination caused by the magnesium adhering to the surface of the object to be polished, and the effect of this on the performance of a device to which the object to be polished is applied. In particular, in semiconductor applications, it is preferable because it reduces deterioration of quality caused by the magnesium adhering to the surface of the object to be polished diffusing into the object to be polished, and a decrease in the performance of semiconductor devices manufactured using such objects to be polished. The magnesium content of the tetraalkoxysilane is 0 ppb by mass or more, and is preferably 0.0001 ppb by mass or more because it is easy to produce.

An aluminum content of the tetraalkoxysilane is preferably 2 ppb by mass or less, and more preferably 1.2 ppb by mass or less. When the aluminum content of the tetraalkoxysilane is within the above range, it is preferable because the aluminum content of the resulting silica particles is reduced, and when the silica particles are used for polishing, contamination caused by the aluminum adhering to the surface of the object to be polished, and the effect of this on the performance of a device to which the object to be polished is applied. In particular, in semiconductor applications, it is preferable because it reduces deterioration of quality caused by the aluminum adhering to the surface of the object to be polished diffusing into the object to be polished, and a decrease in the performance of semiconductor devices manufactured using such objects to be polished. The aluminum content of the tetraalkoxysilane is 0 ppb by mass or more, and is preferably 0.0001 ppb by mass or more because it is easy to produce.

A chromium content of the tetraalkoxysilane is preferably 1 ppb by mass or less, and more preferably 0.5 ppb by mass or less. When the chromium content of the tetraalkoxysilane is within the above range, it is preferable because the chromium content of the resulting silica particles is reduced, and when the silica particles are used for polishing, contamination caused by the chromium adhering to the surface of the object to be polished, and the effect of this on the performance of a device to which the object to be polished is applied. In particular, in semiconductor applications, it is preferable because it reduces deterioration of quality caused by the chromium adhering to the surface of the object to be polished diffusing into the object to be polished, and a decrease in the performance of semiconductor devices manufactured using such objects to be polished. The chromium content of the tetraalkoxysilane is 0 ppb by mass or more, and is preferably 0.0001 ppb by mass or more because it is easy to produce.

A manganese content of the tetraalkoxysilane is preferably 1 ppb by mass or less, and more preferably 0.5 ppb by mass or less. When the manganese content of the tetraalkoxysilane is within the above range, it is preferable because the manganese content of the resulting silica particles is reduced, and when the silica particles are used for polishing, contamination caused by the manganese adhering to the surface of the object to be polished, and the effect of this on the performance of a device to which the object to be polished is applied. In particular, in semiconductor applications, it is preferable because it reduces deterioration of quality caused by the manganese adhering to the surface of the object to be polished diffusing into the object to be polished, and a decrease in the performance of semiconductor devices manufactured using such objects to be polished. The manganese content of the tetraalkoxysilane is 0 ppb by mass or more, and is preferably 0.0001 ppb by mass or more because it is easy to produce.

An iron content of the tetraalkoxysilane is preferably 1 ppb by mass or less, and more preferably 0.6 ppb by mass or less. When the iron content of the tetraalkoxysilane is within the above range, it is preferable because the iron content of the resulting silica particles is reduced, and when the silica particles are used for polishing, contamination caused by the iron adhering to the surface of the object to be polished, and the effect of this on the performance of a device to which the object to be polished is applied. In particular, in semiconductor applications, it is preferable because it reduces deterioration of quality caused by the iron adhering to the surface of the object to be polished diffusing into the object to be polished, and a decrease in the performance of semiconductor devices manufactured using such objects to be polished. The iron content of the tetraalkoxysilane is 0 ppb by mass or more, and is preferably 0.0001 ppb by mass or more because it is easy to produce.

A nickel content of the tetraalkoxysilane is preferably 1 ppb by mass or less, and more preferably 0.5 ppb by mass or less. When the nickel content of the tetraalkoxysilane is within the above range, it is preferable because the nickel content of the resulting silica particles is reduced, and when the silica particles are used for polishing, contamination caused by the nickel adhering to the surface of the object to be polished, and the effect of this on the performance of a device to which the object to be polished is applied. In particular, in semiconductor applications, it is preferable because it reduces deterioration of quality caused by the nickel adhering to the surface of the object to be polished diffusing into the object to be polished, and a decrease in the performance of semiconductor devices manufactured using such objects to be polished. The nickel content of the tetraalkoxysilane is 0 ppb by mass or more, and is preferably 0.0001 ppb by mass or more because it is easy to produce.

A zinc content of the tetraalkoxysilane is preferably 15 ppb by mass or less, and more preferably 12 ppb by mass or less. When the zinc content of the tetraalkoxysilane is within the above range, it is preferable because the zinc content of the resulting silica particles is reduced, and when the silica particles are used for polishing, contamination caused by the zinc adhering to the surface of the object to be polished, and the effect of this on the performance of a device to which the object to be polished is applied. In particular, in semiconductor applications, it is preferable because it reduces deterioration of quality caused by the zinc adhering to the surface of the object to be polished diffusing into the object to be polished, and a decrease in the performance of semiconductor devices manufactured using such objects to be polished. The zinc content of the tetraalkoxysilane is 0 ppb by mass or more, and is preferably 0.0001 ppb by mass or more because it is easy to produce.

A copper content of the tetraalkoxysilane is preferably 1 ppb by mass or less, and more preferably 0.5 ppb by mass or less. When the copper content of the tetraalkoxysilane is within the above range, it is preferable because the copper content of the resulting silica particles is reduced, and when the silica particles are used for polishing, contamination caused by the copper adhering to the surface of the object to be polished, and the effect of this on the performance of a device to which the object to be polished is applied. In particular, in semiconductor applications, it is preferable because it reduces deterioration of quality caused by the copper adhering to the surface of the object to be polished diffusing into the object to be polished, and a decrease in the performance of semiconductor devices manufactured using such objects to be polished. The copper content of the tetraalkoxysilane is 0 ppb by mass or more, and is preferably 0.0001 ppb by mass or more because it is easy to produce.

A lead content of the tetraalkoxysilane is preferably 1 ppb by mass or less, and more preferably 0.5 ppb by mass or less. When the lead content of the tetraalkoxysilane is within the above range, it is preferable because the lead content of the resulting silica particles is reduced, and when the silica particles are used for polishing, contamination caused by the lead adhering to the surface of the object to be polished, and the effect of this on the performance of a device to which the object to be polished is applied. In particular, in semiconductor applications, it is preferable because it reduces deterioration of quality caused by the lead adhering to the surface of the object to be polished diffusing into the object to be polished, and a decrease in the performance of semiconductor devices manufactured using such objects to be polished. The lead content of the tetraalkoxysilane is 0 ppb by mass or more, and is preferably 0.0001 ppb by mass or more because it is easy to produce.

A titanium content of the tetraalkoxysilane is preferably 2 ppb by mass or less, and more preferably 1.2 ppb by mass or less. When the titanium content of the tetraalkoxysilane is within the above range, it is preferable because the titanium content of the resulting silica particles is reduced, and when the silica particles are used for polishing, contamination caused by the titanium adhering to the surface of the object to be polished, and the effect of this on the performance of a device to which the object to be polished is applied. In particular, in semiconductor applications, it is preferable because it reduces deterioration of quality caused by the titanium adhering to the surface of the object to be polished diffusing into the object to be polished, and a decrease in the performance of semiconductor devices manufactured using such objects to be polished. The titanium content of the tetraalkoxysilane is 0 ppb by mass or more, and is preferably 0.0001 ppb by mass or more because it is easy to produce.

A silver content of the tetraalkoxysilane is preferably 1 ppb by mass or less, and more preferably 0.5 ppb by mass or less. When the silver content of the tetraalkoxysilane is within the above range, it is preferable because the silver content of the resulting silica particles is reduced, and when the silica particles are used for polishing, contamination caused by the silver adhering to the surface of the object to be polished, and the effect of this on the performance of a device to which the object to be polished is applied. In particular, in semiconductor applications, it is preferable because it reduces deterioration of quality caused by the silver adhering to the surface of the object to be polished diffusing into the object to be polished, and a decrease in the performance of semiconductor devices manufactured using such objects to be polished. The silver content of the tetraalkoxysilane is 0 ppb by mass or more, and is preferably 0.0001 ppb by mass or more because it is easy to produce.

A metal content of the tetraalkoxysilane is preferably 50 ppb by mass or less, more preferably 40 ppb by mass or less, and even more preferably 35 ppb by mass or less. When the metal content of the tetraalkoxysilane is within the above range, it is preferable because the metal content of the resulting silica particles is reduced, and when the silica particles are used for polishing, contamination caused by the metal adhering to the surface of the object to be polished, and the effect of this on the performance of a device to which the object to be polished is applied. In particular, in semiconductor applications, it is preferable because it reduces deterioration of quality caused by the metal adhering to the surface of the object to be polished diffusing into the object to be polished, and a decrease in the performance of semiconductor devices manufactured using such objects to be polished. The metal content of the tetraalkoxysilane is 0 ppb by mass or more, and is preferably 0.0001 ppb by mass or more because it is easy to produce.

The content of each metal in the tetraalkoxysilane in the present specification is a value measured by High-frequency Inductively Coupled Plasma Mass Spectrometry (ICP-MS). The target metals are sodium, potassium, cobalt, magnesium, aluminum, calcium, chromium, manganese, iron, nickel, zinc, copper, lead, titanium, and silver, and the sum of the contents of these metals is the metal content.

The solution (B) may contain only tetraalkoxysilane without containing a solvent, but it is preferable to contain a solvent since this provides excellent dispersibility of the tetraalkoxysilane in the reaction liquid.

Examples of the solvent in the solution (B) include methanol, ethanol, propanol, isopropanol, ethylene glycol, and the like. These solvents may be used alone or in combination of two or more. Among these solvents, alcohols are preferred, methanol and ethanol are more preferred, and methanol is even more preferred. These alcohols are excellent in convenience in production because the by-products are the same as those used in the hydrolysis reaction and the condensation reaction.

The concentration of the tetraalkoxysilane in the solution (B) is preferably 60% by mass to 95% by mass, and more preferably 70% by mass to 90% by mass, based on 100% by mass of the solution (B). When the concentration of the tetraalkoxysilane in the solution (B) is 60% by mass or more, the reaction liquid is likely to be uniform. When the concentration of the tetraalkoxysilane in the solution (B) is 95% by mass or less, the formation of a gel-like substance can be suppressed.

The concentration of the solvent in the solution (B) is preferably 5% by mass to 40% by mass, and more preferably 10% by mass to 30% by mass, based on 100% by mass of the solution (B). When the concentration of the solvent in the solution (B) is 5% by mass or more, the formation of a gel-like substance can be suppressed. When the concentration of the solvent in the solution (B) is 40% by mass or less, the reaction liquid is likely to be uniform.

The addition rate of the solution (B) per hour relative to the volume of the solution (A) is preferably 0.05 kg/hour/L to 1.3 kg/hour/L, and more preferably 0.1 kg/hour/L to 0.8 kg/hour/L. When the addition rate of the solution (B) is 0.05 kg/hour/L or more, the productivity of the silica particles is excellent. When the addition rate of the solution (B) is 1.3 kg/hour/L or less, the formation of a gel-like substance can be suppressed.

The solution (C) contains an alkaline catalyst.

Examples of the alkaline catalyst in the solution (C) include ethylenediamine, diethylenetriamine, triethylenetetramine, ammonia, urea, ethanolamine, tetramethylammonium hydroxide, and the like. These alkaline catalysts may be used alone or in combination of two or more. Among these alkaline catalysts, ammonia is preferred. Ammonia has excellent catalytic action, is easy to control the particle shape, can suppress the inclusion of metal impurities, is highly volatile, and therefore easy to be removed after the hydrolysis reaction and the condensation reaction.

It is preferable that the solution (C) contains a solvent, since this can reduce the fluctuation in the concentration of the alkaline catalyst in the reaction liquid.

Examples of the solvent in the solution (C) include water, methanol, ethanol, propanol, isopropanol, ethylene glycol, and the like. These solvents may be used alone or in combination of two or more. Among these solvents, water and alcohol are preferred, and water is more preferred. Water, alcohol, especially water, is excellent in convenience in production because the by-products are the same as those used in the hydrolysis reaction and the condensation reaction.

The concentration of the alkaline catalyst in the solution (C) is preferably 0.5% by mass to 10% by mass, and more preferably 1% by mass to 6% by mass, based on 100% by mass of the solution (C). When the concentration of the alkaline catalyst in the solution (C) is 0.5% by mass or more, it is easy to adjust the concentration of the alkaline catalyst in the reaction liquid from the start of the reaction to the end of the reaction. When the concentration of the alkaline catalyst in the solution (C) is 10% by mass or less, it is possible to reduce the fluctuation in the concentration of the alkaline catalyst in the reaction liquid.

The concentration of the solvent in the solution (C) is preferably 90% by mass to 99.5% by mass, and more preferably 94% by mass to 99% by mass, based on 100% by mass of the solution (C). When the concentration of the solvent in the solution (C) is 90% by mass or more, it is possible to reduce the fluctuation in the concentration of the alkaline catalyst in the reaction liquid. When the concentration of the solvent in the solution (C) is 99.5% by mass or less, it is easy to adjust the concentration of the alkaline catalyst in the reaction liquid from the start of the reaction to the end of the reaction.

The addition of the solution (B) and the solution (C) is preferably carried out into the liquid of the solution (A). By adding the solution (B) and the solution (C) into the liquid of the solution (A), when it is desired to use a highly volatile alkaline catalyst such as ammonia and when it is desired to proceed with a hydrolysis reaction and a condensation reaction at a high reaction temperature, the mixability of each component in the reaction liquid is improved, abnormal reactions in the air can be suppressed, and the particle shape can be easily controlled.

The addition into the liquid means addition below the liquid level. For example, by making the supply outlet of the solution (B) and the supply outlet of the solution (C) below the liquid level of the solution (A), the solution (B) and the solution (C) can be added into the liquid of the solution (A).

The timing of adding the solution (B) and the solution (C) to the solution (A) may be the same or different. For example, the solution (B) and the solution (C) may be added alternately. It is preferable that the timing of adding the solution (B) and the solution (C) to the solution (A) is the same, since this reduces the fluctuation in the reaction composition and does not complicate the operation.

The pH in the process of subjecting the tetraalkoxysilane to the hydrolysis reaction and the condensation reaction is preferably 8 to 14, more preferably 8.2 to 13, and even more preferably 8.5 to 12. When the pH in the process is 8 or higher, the reaction rate of the hydrolysis reaction and the condensation reaction is excellent, and the aggregation of the silica particles can be suppressed. When the pH in the process is 14 or lower, the shape of the silica particles is easily controlled, and the smoothness of the silica particle surface is excellent.

The reaction temperature of the hydrolysis reaction and the condensation reaction is preferably 5°C to 50°C, and more preferably 10°C to 45°C. When the reaction temperature is 5°C or higher, the reaction does not proceed too slowly, and controllability is excellent. When the reaction temperature is 50°C or lower, the balance between the hydrolysis reaction rate and the condensation reaction rate is excellent.

The concentration of water in the reaction system for the hydrolysis reaction and the condensation reaction is preferably maintained at 3% by mass to 30% by mass, and more preferably at 5% by mass to 25% by mass, based on the total amount of 100% by mass in the reaction system. When the concentration of water in the reaction system is 3% by mass or more, the hydrolysis reaction rate of the tetraalkoxysilane is easily controlled. When the concentration of water in the reaction system is 30% by mass or less, the reaction balance between the hydrolysis reaction and the condensation reaction is excellent, and the particle shape is easily controlled.

The concentration of the alkaline catalyst in the reaction system for the hydrolysis reaction and the condensation reaction is preferably maintained at 0.5% by mass to 2.0% by mass, and more preferably at 0.6% by mass to 1.5% by mass, based on the total amount of 100% by mass in the reaction system. When the concentration of the alkaline catalyst in the reaction system is 0.5% by mass or more, the aggregation of the silica particles is suppressed, and the dispersion stability of the silica particles in the dispersion liquid is excellent. When the concentration of the alkaline catalyst in the reaction system is 2.0% by mass or less, the reaction does not proceed too quickly, and the reaction controllability is excellent.

The hydrolysis reaction and the condensation reaction are preferably carried out in a reaction vessel having a fluororesin coating or a glass layer on the inner wall surface, that is, a reaction vessel having a fluororesin coating or a glass layer formed on the inner wall surface, and are particularly preferably carried out in a reaction vessel having a fluororesin coating on the inner wall surface. By carrying out the hydrolysis reaction and the condensation reaction in a reaction vessel having a fluororesin coating or a glass layer on the inner wall surface, it is easy to reduce metal contamination of the silica particles from the inner wall of the reaction vessel.

The reaction vessel used for the hydrolysis reaction and the condensation reaction is preferably one in which the contact area of the reaction liquid in the hydrolysis reaction and the condensation reaction per unit volume (1 m$^3$) with the reaction vessel is 5 m$^2$ or less, that is, the ratio of the contact area of the reaction liquid to the unit volume of the reaction liquid (hereinafter sometimes referred to as the "contact area ratio to the reaction vessel") is 5 m$^{-1}$ or less, and more preferably the contact area ratio to the reaction vessel is 4 m$^{-1}$ or less.

When the contact area ratio to the reaction vessel is 5 m$^{-1}$ or less, it is easy to reduce metal contamination of the silica particles from the inner wall of the reaction vessel. On the other hand, from the viewpoint of temperature controllability of the reaction liquid in the hydrolysis reaction and the condensation reaction, the contact area ratio to the reaction vessel is preferably 1 m$^{-1}$ or more, and more preferably 3 m$^{-1}$ or more.

The volume of the reaction vessel in which the hydrolysis reaction and the condensation reaction are performed is preferably 1000 L or more, and more preferably 2000 L or more. When the volume of the reaction vessel is 1000 L or more, the metal ratio per unit volume when metal is mixed into the reaction liquid is reduced, making it easier to reduce the metal content of the obtained silica particles.

On the other hand, from the viewpoint of temperature controllability of the reaction liquid during the hydrolysis reaction and the condensation reaction, the volume of the reaction tank is preferably 20000 L or less.

In the method for producing the silica particle of the present invention, it is preferable to carry out the reactions in such a reaction tank so that the amount of reaction liquid during the hydrolysis reaction and the condensation reaction is 16000 L or less, particularly 8000 L or less, and 800 L or more.

The method for producing the silica particle preferably further includes the following step (1), since it is possible to remove unnecessary components and add necessary components.

Step (1): A step of concentrating the obtained dispersion of the silica particles and adding a dispersion medium.

In the step (1), either the concentration of the dispersion of the silica particles or the addition of the dispersion medium in step (1) may be carried out first.

The method of concentrating the dispersion of the silica particles is not particularly limited, and examples thereof include a heat concentration method, a membrane concentration method, and the like.

To concentrate the dispersion of the silica particles by the heat concentration method, the dispersion may be heated and concentrated under normal pressure or reduced pressure.

To concentrate the dispersion of the silica particles by the membrane concentration method, a membrane separation by an ultrafiltration method is preferred. Here, the main purpose of the ultrafiltration method is to remove unnecessary components such as intermediate products. The molecular weight cut-off of the ultrafiltration membrane used here is selected in accordance with the intermediate products in the dispersion, so as to be able to filter and separate and remove the intermediate products.

Examples of the materials for the ultrafiltration membrane include polysulfone, polyacrylonitrile, sintered metal, ceramic, carbon, and the like. Examples of the form of the ultrafiltration membrane include a spiral type, a tubular type, a hollow fiber type, and the like.

Examples of the dispersion medium added to the dispersion of the silica particles include water, methanol, ethanol, propanol, isopropanol, ethylene glycol, and the like. These dispersion media may be used alone or in combination of two or more. Among these dispersion media, water and alcohol are preferred, and water is more preferred, because they have excellent affinity with the silica particles.

(Silica sol)

The silica sol of the present invention contains the silica particle of the present invention.

The silica sol of the present invention may be produced by using the dispersion of the silica particle of the present invention as it is, or by removing unnecessary components from the dispersion of the silica particle of the present invention or adding necessary components.

The silica sol of the present invention preferably contains the silica particles and a dispersion medium.

Examples of the dispersion medium in the silica sol include water, methanol, ethanol, propanol, isopropanol, ethylene glycol, and the like. One or more of these dispersion media in the silica sol may be used alone, or two or more may be used in combination. Among these dispersion media in the silica sol, water and alcohol are preferred, and water is more preferred, because they have excellent affinity with the silica particles.

The content of the silica particles in the silica sol is preferably 2% by mass to 50% by mass, more preferably 4% by mass to 40% by mass, and even more preferably 5% by mass to 30% by mass, based on the total amount of 100 % by mass of the silica sol. When the content of the silica particles in the silica sol is 2% by mass or more, the polishing rate for the object to be polished, typically a silicon wafer, is excellent. When the content of the silica particles in the silica sol is 50% by mass or less, the aggregation of the silica particles in the silica sol or the polishing composition can be suppressed, and the storage stability of the silica sol or the polishing composition is excellent.

The content of the dispersion medium in the silica sol is preferably 50% by mass to 98% by mass, more preferably 60% by mass to 96% by mass, and even more preferably 70% by mass to 95% by mass, based on the total amount of 100 % by mass of the silica sol. When the content of the dispersion medium in the silica sol is 50% by mass or more, the aggregation of the silica particles in the silica sol or the polishing composition can be suppressed, and the storage stability of the silica sol or the polishing composition is excellent. When the content of the dispersion medium in the silica sol is 98% by mass or less, the polishing rate for the object to be polished, typically a silicon wafer, is excellent.

The content of the silica particles and the dispersion medium in the silica sol can be set to a desired range by removing unnecessary components from the components in the obtained dispersion of the silica particles and adding necessary components.

In addition to the silica particles and the dispersion medium, the silica sol may contain other components such as an oxidizing agent, a preservative, an antifungal agent, a pH adjuster, a pH buffer, a surfactant, a chelating agent, an antibacterial biocide, and the like, as necessary, within the range that does not impair the performance of the silica sol.

In particular, it is preferable to include an antibacterial biocide in the silica sol, as this provides excellent storage stability for the silica sol.

The antibacterial biocide is preferably hydrogen peroxide, as it has excellent affinity with the silica sol. Examples of the antibacterial biocide also include those commonly referred to as fungicides.

The content of the antibacterial biocide in the silica sol is preferably 0.0001% by mass to 10% by mass, and more preferably 0.001% by mass to 1% by mass, based on the total amount of 100% by mass of the silica sol. When the content of the antibacterial biocide in the silica sol is 0.0001% by mass or more, the silica sol has excellent storage stability. When the content of the antibacterial biocide in the silica sol is 10% by mass or less, the inherent performance of the silica sol is not impaired.

The pH of the silica sol is preferably 6.0 to 8.0, more preferably 6.5 to 7.8. When the pH of the silica sol is 6.0 or higher, it is possible to provide excellent dispersion stability and inhibit the aggregation of the silica particles. When the pH of the silica sol is 8.0 or lower, it is possible to prevent dissolution of the silica particles and provide excellent long-term storage stability.

The pH of the silica sol can be set to a desired range by adding a pH adjuster.

(Polishing composition)

The polishing composition of the present invention contains the silica sol of the present invention.

The polishing composition of the present invention may contain, in addition to the silica sol of the present invention, other components such as a water-soluble polymer, a basic compound, a polishing accelerator, a surfactant, a hydrophilic compound, a preservative, an antifungal agent, a pH adjuster, a pH buffer, a surfactant, a chelating agent, an antibacterial biocide, and the like, as necessary, within the range of not impairing the performance of the composition.

The polishing composition is obtained by mixing the silica sol of the present invention and, as necessary, other components. In consideration of storage and transportation, the polishing composition of the present invention may be prepared at a high concentration and then diluted with water or the like immediately before polishing.

(Polishing method)

The polishing method of the present invention is a method of polishing using a polishing composition containing the silica sol of the present invention.

The polishing composition preferably uses the polishing composition described above.

Specific examples of the polishing method include, a method in which the surface of a silicon wafer is pressed against a polishing pad, the polishing composition of the present invention is dropped onto the polishing pad, and the surface of the silicon wafer is polished.

(Method of manufacturing semiconductor wafer)

The method of manufacturing a semiconductor wafer of the present invention includes a step of polishing using the polishing composition of the present invention. Specific examples of the polishing composition and the polishing method are as described above.

Examples of the semiconductor wafer include a silicon wafer, a compound semiconductor wafer, and the like.

(Method of manufacturing semiconductor device)

The method of manufacturing a semiconductor device of the present invention includes a step of polishing using the polishing composition of the present invention. Specific examples of the polishing composition and the polishing method are as described above.

(Applications)

The silica particle of the present invention and the silica sol of the present invention can be suitably used for polishing applications. For example, they can be used for polishing a semiconductor material such as a silicon wafer, and the like, polishing an electronic material such as a hard disk substrate, and the like, polishing in a planarization process in manufacture of a integrated circuit (chemical mechanical polishing), polishing a synthetic quartz glass substrate used for a photomask or liquid crystal, polishing a magnetic disk substrate, and the like. Among them, they can be suitably used for polishing a silicon wafer and chemical mechanical polishing. They can be particularly suitably used for final polishing of a silicon wafer and final polishing of chemical mechanical polishing.

Examples

The present invention will be described in more detail below using Examples. The present invention is not limited to the description of the following Examples, so long as it does not deviate from the gist of the present invention.

(Measurement of average primary particle diameter)

Each silica sol (dispersion of the silica particles) obtained in the Examples and Comparative Examples was dried at 150°C, and the BET specific surface area of the silica particles was measured using an automatic specific surface area measuring device (model name "Belsorp MR1", manufactured by Microtrac Bell Corporation.). Assuming that the silica particles are true spherical, the density was set to 2.2 g/cm$^3$, and the average primary particle diameter was calculated using the following formula (1).

Average primary particle diameter (nm) = 6000 / (BET specific surface area (m$^2$/g) x density (g/cm$^3$) )    (1)

(Measurement of average secondary particle diameter and cv value)

The average secondary particle diameter of the silica particles in each silica sol (dispersion of the silica particles) obtained in the Examples and Comparative Examples was measured using a dynamic light scattering particle diameter measurement device "Zetasizer Nano ZS" (model name, manufactured by Malvern Instruments), and the cv value was calculated using the following formula (2).

cv value = (standard deviation (nm) / average secondary particle diameter (nm)) x 100    (2)

(Calculation of association ratio)

The association ratio was calculated from the measured average primary particle diameter and average secondary particle diameter using the following formula (3).

Association ratio = average secondary particle diameter / average primary particle diameter    (3)

(Measurement of surface silanol group density)

From each silica sol (dispersion of the silica particles) obtained in the Examples and Comparative Examples, an amount equivalent to 1.5 g of silica particles was taken into a 200 mL tall beaker, and pure water was added to make the liquid volume 90 mL.
In an environment of 25°C, a pH electrode was inserted into the tall beaker, and the test liquid was stirred for 5 minutes with a magnetic stirrer. While continuing to stir with the magnetic stirrer, 0.1 mol/L of hydrochloric acid aqueous solution was added until the pH reached **3.6**. The pH electrode was removed from the tall beaker, and while continuing to stir with the magnetic stirrer, 30 g of sodium chloride was added, and pure water was gradually added until the sodium chloride was completely dissolved. Finally, pure water was added until the total volume of the test liquid was 150 mL, and the test liquid was stirred with the magnetic stirrer for 5 minutes to obtain a test liquid.
The tall beaker containing the obtained test liquid was set in an automatic titration device "COM-1600" (manufactured by Hiranuma Co., Ltd.), and the pH electrode and burette provided with the device were inserted into the tall beaker. While stirring the test liquid with the magnetic stirrer, 0.1 mol/L sodium hydroxide aqueous solution was dropped through the burette, and the titration amount A (mL) of the 0.1 mol/L sodium hydroxide aqueous solution required to change the pH from 4.0 to 9.0 was measured.
The consumption amount V (mL) of the 0.1 mol/L sodium hydroxide aqueous solution required for the pH to change from 4.0 to 9.0 per 1.5 g of the silica particles was calculated using the following formula (4), and the surface silanol group density ρ (pieces/nm$^2$) of the silica particles was calculated using the following formula (5).

$$V = (A \times f \times 100 \times 1.5) / (W \times C) \ ... \ (4)$$

A: Titration amount (mL) of the 0.1 mol/L sodium hydroxide aqueous solution required to change the pH per 1.5 g of the silica particles from 4.0 to 9.0

f: Titer of the 0.1 mol/L sodium hydroxide solution used

C: Concentration of the silica particles in the silica sol (% by mass)

W: Amount of the silica sol collected (g)

$$\rho = (B \times N_A) / (10^{18} \times M \times S_{BET}) \ ... \ (5)$$

B: Amount (mol) of the sodium hydroxide required to change the pH of the silica particles per 1.5g from 4.0 to 9.0 calculated from V

$N_A$: Avogadro's number (pieces/mol)

M: Amount of the silica particles (1.5 g)

$S_{BET}$: Specific surface area of the silica particles measured when calculating the average primary particle diameter (m$^2$/g)

(Measurement of metal impurity content)

A silica sol containing 0.4 g of the silica particles obtained in each of Examples and Comparative Examples was accurately weighed, sulfuric acid and hydrofluoric acid were added, and the mixture was heated, dissolved, and evaporated. Pure water was added to the remaining sulfuric acid droplets so that the total amount was exactly 10 g to prepare a test liquid. The metal impurity content was measured using a high frequency inductively coupled plasma mass spectrometer "ELEMENT2" (model name, manufactured by Thermo Fisher Scientific).

[Example 1]

Tetramethoxysilane was produced according to the description in JP H8-325272 A. The metal content of the tetramethoxysilane produced is shown in Table 1.

A solution (B) was prepared by mixing tetramethoxysilane and methanol at a volume ratio of 4.4:1. Separately, a solution (C) of 3.0% by mass ammonia aqueous solution was prepared. A solution (A) prepared by mixing methanol, pure water, and ammonia was charged into a reaction vessel equipped with a thermometer, a stirrer, and a supply pipe, and the inner surface of which was coated with tetrafluoroethylene-perfluoroalkoxyethylene copolymer resin (PFA). The concentration of water in the solution (A) was 11.7% by mass, and the concentration of ammonia in the solution (A) was 0.73% by mass.

100% by volume of the solution (B) and 33% by volume of the solution (C) were each added dropwise at a constant speed to 166% by volume of the solution (A) at 22°C over a period of 200 minutes to obtain a dispersion of the silica particles.

The contact area ratio of the reaction solution to the reaction vessel during the hydrolysis reaction and the condensation reaction was 3.7 m$^{-1}$.

The temperature of the obtained dispersion of the silica particles was raised to remove methanol and ammonia while adjusting the liquid volume by adding pure water so that the silica particle content was approximately 20% by mass, thereby obtaining a dispersion of the silica particles having a silica particle content of approximately 20% by mass.

The obtained silica particles were confirmed to be amorphous by a halo pattern in a wide-angle X-ray scattering measurement.

[Comparative Example 1]

A commercially available silica particle dispersion (product name "PL-3", manufactured by Fuso Chemical Co., Ltd.) was used as is.

[Comparative Example 2]

Tetramethoxysilane was produced according to the description in JP H8-325272 A. The metal content of the tetramethoxysilane produced is shown in Table 1.

A solution (B) was prepared by mixing tetramethoxysilane and methanol at a volume ratio of 4.4:1. Separately, a solution (C) of 3.0% by mass ammonia aqueous solution was prepared. A solution (A) prepared by mixing methanol, pure water, and ammonia was charged into a glass reaction vessel equipped with a thermometer, a stirrer, and a supply pipe. The concentration of water in the solution (A) was 11.7% by mass, and the concentration of ammonia in the solution (A) was 0.73% by mass.

100% by volume of the solution (B) and 33% by volume of the solution (C) were each added dropwise at a constant speed to 166% by volume of the solution (A) at 22°C over a period of 200 minutes to obtain a dispersion of the silica particles.

The contact area ratio of the reaction solution to the reaction vessel during the hydrolysis reaction and the condensation reaction was 48.7 $m^{-1}$.

The temperature of the obtained dispersion of the silica particles was raised to remove methanol and ammonia while adjusting the liquid volume by adding pure water so that the silica particle content was approximately 20% by mass, thereby obtaining a dispersion of the silica particles with a silica particle content of approximately 20% by mass.

The obtained silica particles were confirmed to be amorphous by a halo pattern in a wide-angle X-ray scattering measurement.

The evaluation results for each silica particle are shown in Table 1.

[Table 1]

| Sample name | | Raw material | Example 1 | Comparative Example 1 | Comparative Example 2 |
|---|---|---|---|---|---|
| Na | [ppb by mass] | <0.5 | 9.6 | 133.0 | 5882.4 |
| Mg | [ppb by mass] | <0.5 | <0.5 | 2.0 | 167.4 |
| Al | [ppb by mass] | <0.5 | 1.1 | 10.8 | 905.0 |
| K | [ppb by mass] | <0.5 | <0.5 | 41.4 | 1583.7 |
| Ca | [ppb by mass] | <0.5 | 5.9 | 9.9 | 769.2 |
| Cr | [ppb by mass] | <0.5 | <0.5 | <0.5 | 24.0 |
| Mn | [ppb by mass] | <0.5 | <0.5 | <0.5 | 4.5 |
| Fe | [ppb by mass] | <0.5 | 0.5 | 4.4 | 49.8 |
| Co | [ppb by mass] | <0.5 | <0.5 | 4.4 | 0.5 |
| Ni | [ppb by mass] | <0.5 | <0.5 | <0.5 | 8.1 |
| Cu | [ppb by mass] | <0.5 | <0.5 | <0.5 | 16.3 |
| Ti | [ppb by mass] | <0.5 | 1.1 | 0.5 | 113.1 |
| Zn | [ppb by mass] | <0.5 | 11.8 | <0.5 | 357.5 |
| Ag | [ppb by mass] | <0.5 | <0.5 | <0.5 | 1.4 |
| Pb | [ppb by mass] | <0.5 | <0.5 | <0.5 | 9.5 |
| Average primary particle diameter | [nm] | - | 30.0 | 36.1 | 32.4 |
| Average secondary particle diameter | [nm] | - | 62.1 | 71.2 | 66.6 |
| Association ratio | | - | 2.07 | 1.97 | 2.06 |
| cv value | [%] | - | 30.3 | 28.6 | 29.2 |
| Surface silanol group density | [pieces/nm$^2$] | - | 5.2 | 5.2 | 5.7 |

As can be seen from Table 1, the silica particles obtained in Example 1 have almost the same physical properties, such as particle diameter, as the silica particles used in Comparative Example 1, but the contents of most of the metals are low.

The silica particles obtained in Example 1 have an extremely low metal content compared to the commercially available silica particles of Comparative Example 1, and when used for polishing, it is possible to suppress the adhesion of metals to the surface of the object to be polished, thereby reducing the negative effects on the performance of the object to which the polished object is applied.

Furthermore, the silica particles obtained in Example 1 have almost the same physical properties, such as particle diameter, as the silica particles used in Comparative Example 2, but the contents of all of the metals are low.

The silica particles obtained in Example 1 have an extremely low metal content compared to the silica particles of Comparative Example 2 obtained using a glass reaction vessel under a condition of a high contact area ratio of the reaction liquid to the reaction vessel, and when used for polishing, it is possible to suppress the adhesion of metals to the surface of the object to be polished, thereby reducing the negative effects on the performance of the object to which the polished object is applied.

Although the present invention has been described in detail using specific embodiments, it is clear to those skilled in the art that various modifications are possible within the scope of the invention.

This application is based on Japanese Patent Application No. 2022-196462 filed on December 8, 2022, the entire contents of which is incorporated by reference.

Industrial Applicability

The silica particle of the present invention and the silica sol of the present invention can be suitably used for polishing applications. For example, they can be used for polishing a semiconductor material such as a silicon wafer, and the like, polishing an electronic material such as a hard disk substrate, and the like, polishing in a planarization process in manufacture of a integrated circuit (chemical mechanical polishing), polishing a synthetic quartz glass substrate used for a photomask or liquid crystal, polishing a magnetic disk substrate, and the like. Among them, they can be suitably used for polishing a silicon wafer and chemical mechanical polishing, and can be particularly suitably used for final polishing of a silicon wafer and final polishing of chemical mechanical polishing.

**Claims**

1. A silica particle satisfying at least one of the following characteristics (a) to (c).

   (a) A content of sodium is 15 ppb by mass or less.
   (b) A content of potassium is 5 ppb by mass or less.
   (c) A content of calcium is 9 ppb by mass or less.

2. The silica particle according to claim 1, wherein the silica particle satisfies at least two of the characteristics (a) to (c).

3. The silica particle according to claim 2, wherein the silica particle satisfies all of the characteristics (a) to (c).

4. The silica particle according to any one of claims 1 to 3, wherein the silica particle has a metal content of 50 ppb by mass or less.

5. The silica particle according to any one of claims 1 to 3, wherein the silica particle is amorphous.

6. The silica particle according to any one of claims 1 to 3, wherein the silica particle is mainly composed of an alkoxysilane condensate.

7. A method for producing the silica particle according to any one of claims 1 to 3, wherein the method comprises a step in which tetraalkoxysilane is subjected to a hydrolysis reaction and a condensation reaction in a reaction vessel having an inner wall surface coated with a fluororesin.

8. The method for producing the silica particle according to claim 7, wherein the reaction vessel is a reaction vessel having a contact area of the reaction solution per unit volume with the reaction vessel during the hydrolysis reaction and the condensation reaction of 5 m$^{-1}$ or less.

9. The method for producing the silica particle according to claim 7, wherein a metal content of the tetraalkoxysilane is 50 ppb by mass or less.

10. A silica sol comprising the silica particle according to any one of claims 1 to 3.

11. The silica sol according to claim 10, wherein a content of the silica particle is 2% by mass to 50% by mass in a total amount of 100% by mass of the silica sol.

12. A polishing composition comprising the silica sol according to claim 10.

13. A polishing method using the polishing composition according to claim 12.

14. The polishing method according to claim 13, wherein the polishing method using the polishing composition is conducted in a final polishing step in a polishing process.

15. A method for manufacturing a semiconductor wafer, wherein the method comprises a step of polishing using the polishing composition according to claim 12.

16. A method for manufacturing a semiconductor device, wherein the method comprises a step of polishing using the polishing composition according to claim 12.

**EP 4 631 913 A1**

## INTERNATIONAL SEARCH REPORT

International application No.

**PCT/JP2023/043677**

### A. CLASSIFICATION OF SUBJECT MATTER

*C01B 33/18*(2006.01)i; *C01B 33/141*(2006.01)i; *C09K 3/14*(2006.01)i; *H01L 21/304*(2006.01)i
FI: C01B33/18 Z; C01B33/141; C09K3/14 550Z; C09K3/14 550D; H01L21/304 622D

According to International Patent Classification (IPC) or to both national classification and IPC

### B. FIELDS SEARCHED

Minimum documentation searched (classification system followed by classification symbols)

C01B33/18; C01B33/141; C09K3/14; H01L21/304

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

JSTPlus/JSTChina/JST7580 (JDreamIII)

### C. DOCUMENTS CONSIDERED TO BE RELEVANT

| Category* | Citation of document, with indication, where appropriate, of the relevant passages | Relevant to claim No. |
|---|---|---|
| X | JP 2013-220976 A (TAMA KAGAKU KOGYO KK) 28 October 2013 (2013-10-28) claims, paragraphs [0001], [0002], [0042]-[0047] | 1-3, 5, 6, 10-16 |
| Y | | 1-16 |
| X | WO 2016/117560 A1 (FUJIMI INC) 28 July 2016 (2016-07-28) claims, paragraphs [0002], [0051], [0058]-[0088] | 1, 2, 5, 6, 10, 12-16 |
| Y | | 1-16 |
| X | JP 8-208214 A (MITSUBISHI CHEMICAL CORPORATION) 13 August 1996 (1996-08-13) claims, paragraphs [0005], [0006], [0009]-[0012] | 1, 5, 6 |
| Y | | 1-9 |
| Y | JP 2022-63814 A (NABESHO GSK) 22 April 2022 (2022-04-22) paragraphs [0010], [0024], [0026] | 1-16 |
| Y | JP 2018-80331 A (JGC CATALYSTS & CHEMICALS LTD.) 24 May 2018 (2018-05-24) paragraphs [0005], [0049] | 1-16 |

✓ Further documents are listed in the continuation of Box C.    ✓ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **15 February 2024** | **27 February 2024** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (July 2022)

21

**EP 4 631 913 A1**

### INTERNATIONAL SEARCH REPORT

| International application No. |
|---|
| **PCT/JP2023/043677** |

**C. DOCUMENTS CONSIDERED TO BE RELEVANT**

| Category* | Citation of document, with indication, where appropriate, of the relevant passages | Relevant to claim No. |
|---|---|---|
| P, X | JP 2023-4284 A (MITSUBISHI CHEMICAL CORPORATION) 17 January 2023 (2023-01-17)<br>claims, paragraphs [0084], [0095], [0108]-[0119] | 1-7, 10-13, 15, 16 |

Form PCT/ISA/210 (second sheet) (July 2022)

22

## INTERNATIONAL SEARCH REPORT
### Information on patent family members

International application No.

**PCT/JP2023/043677**

| Patent document cited in search report | | | Publication date (day/month/year) | Patent family member(s) | Publication date (day/month/year) |
|---|---|---|---|---|---|
| JP | 2013-220976 | A | 28 October 2013 | (Family: none) | |
| WO | 2016/117560 | A1 | 28 July 2016 | EP 3248941 A1<br>claims, paragraphs [0002], [0051], [0058]-[0088]<br>US 2017/0362465 A1<br>CN 107207268 A<br>KR 10-2017-0106331 A<br>TW 201630810 A | |
| JP | 8-208214 | A | 13 August 1996 | (Family: none) | |
| JP | 2022-63814 | A | 22 April 2022 | (Family: none) | |
| JP | 2018-80331 | A | 24 May 2018 | US 2018/0127627 A1<br>paragraphs [0008], [0083]<br>KR 10-2018-0051405 A<br>TW 201817846 A | |
| JP | 2023-4284 | A | 17 January 2023 | (Family: none) | |

**REFERENCES CITED IN THE DESCRIPTION**

**Patent documents cited in the description**

- WO 2008015943 A
- JP 2018080331 A
- JP 2010083744 A

- JP H8325272 A
- JP 2022196462 A